# EUROPEAN PATENT APPLICATION

(11) **EP 0 806 678 A2**
(43) Date of publication of application: **12.11.1997**
(21) Application number: 97400989.6
(22) Date of filing: 30.04.1997
(51) Int. Cl.: G01R 31/308, G01R 13/34

(54) **Laser voltage probe methods and apparatus**

(30) Priority: 10.05.1996 US 644344
(71) Applicant: SCHLUMBERGER TECHNOLOGIES, INC., San Jose, California 95110-1397 (US)
(72) Inventor: Talbot, Christopher, Graham, California 94025 (US); Wilsher, Kenneth, Palo Alto, California 94301 (US)
(74) Representative: Lemoyne, Didier

(57) **Abstract**

A laser voltage probe system in which a repetitive stimulus signal is applied to an integrated circuit. A train of laser pulses is generated, and a laser pulse is picked from the train at a selected time during each repetition of the stimulus signal. The picked laser pulses are applied to a semiconductor active region of the integrated circuit which is influenced by voltage on a conductor. Photons reflected from the semiconductor active region are detected to produce a detector signal. The detector signal is sampled in synchrony with application of the laser pulses to the semiconductor active region so as to obtain samples during first gating intervals which depend upon reflected photons and noise and so as to obtain samples during second gating intervals which depend upon noise. Samples obtained during the first gating intervals are integrated with the inverse of samples obtained during the second gating intervals to produce an integrator signal representing a noise-compensated signal. The integrator signal can be compensated for pulse-to-pulse laser power variations.

## Description

The present invention relates to methods and apparatus for acquisition of signal information from a circuit using a laser voltage probe.

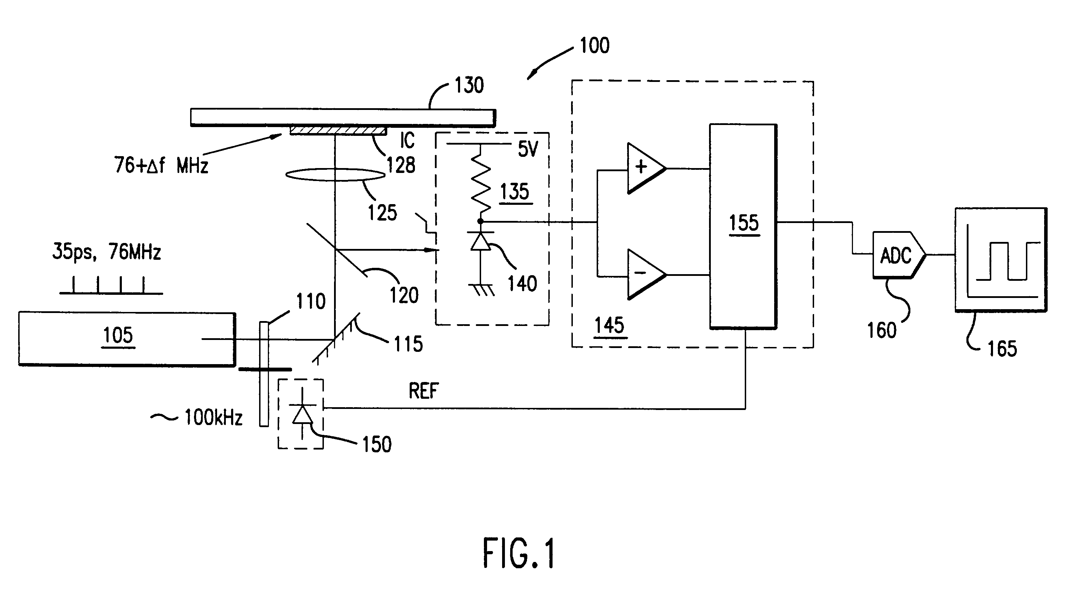

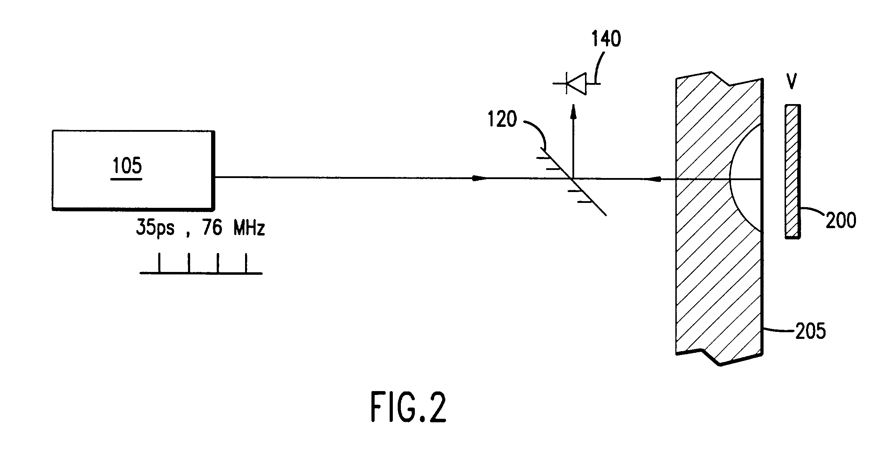

Figure 1 shows schematically a prior-art laser voltage probe arrangement 100. A source 105, such as a Coherent Antares mode-locked YLF laser, or a YAG laser, supplies 35 ps wide laser pulses at a frequency of 76 MHz. A shutter 110 passes selected pulses to mirror 115, from which they are passed through a beam splitter 120 and optics 125 onto a semiconductor active region 128 influenced by a gate electrode of an integrated circuit (IC) device 130. A signal source applies a short duty cycle square wave signal to the conductor at a frequency of 76 + Df MHz, with Df being a small value. The frequency difference Df produces a "beat" between the laser pulse frequency and the applied square-wave signal so as to scan the laser pulses relative to the repetitive signal on the conductor. As explained below with reference to Figure 2, voltage on the conductor determines how much of the laser light incident on the conductor is reflected and how much is absorbed. The reflected photons are passed via beam splitter 120 to a detector circuit 135 where they are detected by a photodiode 140. Detector circuit 135 supplies a detector signal to a phase-sensitive rectifier circuit 145

A reference detector, schematically represented as a photodiode 150, detects the incident light pulses from shutter 110 and provides a reference signal Ref to analog multiplexer 155 of phase-sensitive rectifier 145. Phase-sensitive rectifier produces a waveform output signal which is supplied via an analog-to-digital converter 160 to a display 165. The displayed signal waveform is a time-expanded facsimile of the square-wave signal present on conductor 128 of IC 130.

Figures 2-4 illustrate schematically the principle of operation of the prior-art Figure 1 arrangement. Laser source 105 supplies the laser pulses at a wavelength of 1053 nm, which is close to the band-gap energy of silicon at a gate electrode 200 of IC 130. The pulses may be applied to gate electrode 200 through a thinned region of the silicon substrate 205 of IC 130, as silicon is effectively transparent to light of this wavelength. Absorption of photons by the silicon substrate is modified by potential on the gate electrode. The effect is strongest across the semiconductor junction where the field strength is strongest. Reflected photons pass back through the thinned silicon substrate and via beam splitter 120, then are detected by photodiode 140.

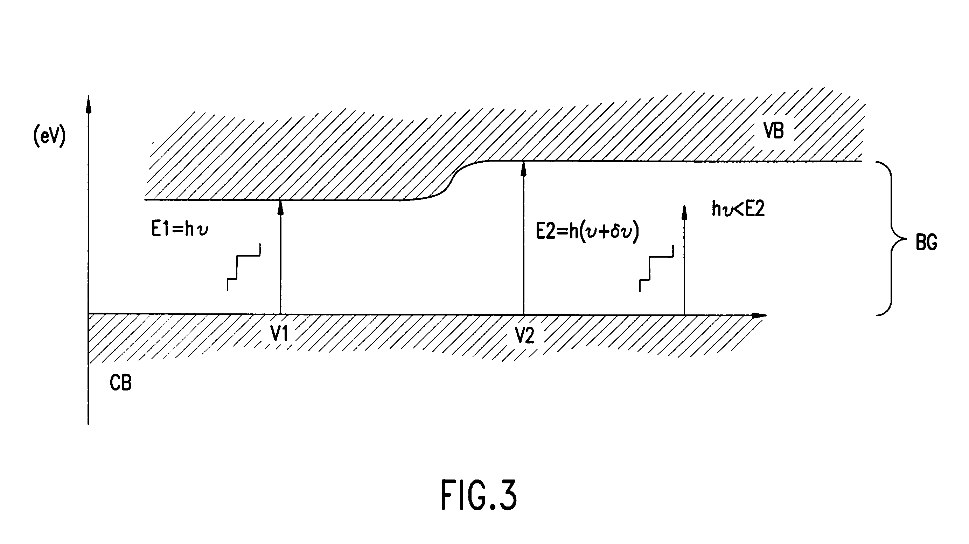

Figure 3 shows the band-gap energy (eV) of silicon (i.e. the energy gap between the conduction band CB and the valence band VB) at gate electrode 200 in two states: when the gate electrode is at a potential V1 and when the gate electrode is at a potential V2. When at potential V1, the band-gap energy of the active region is E1 = hu, which is slightly less than the energy of the incident photons. Incident photons are absorbed by electrons in the active region and unabsorbed photons are reflected. When gate electrode 200 is at potential V2, the band-gap energy of the active region is E2 = h(u + Du), which is greater than the energy of the incident photons. Incident photons are thus reflected by electrons of the gate electrode, as the electrons cannot absorb photons having an energy level less than that of the band gap BG. The reflected photons pass via substrate 205 and beam splitter 120 to photodiode 140, which produces a detector signal modulated by the potential of the gate electrode. This modulation is on the order of 1 - 2 parts per million (ppm) for a 1-volt change in the gate potential (gate potential is between 1 - 3 volts in a typical circuit).

Photons produced by laser source 105 have a range of energies over a narrow band. Within that range, the quantity of photons which are reflected will depend upon the potential of gate electrode 200. As the potential of gate electrode 200 is modulated between levels V1 and V2, the quantity of reflected photons varies and the detector signal is likewise modulated.

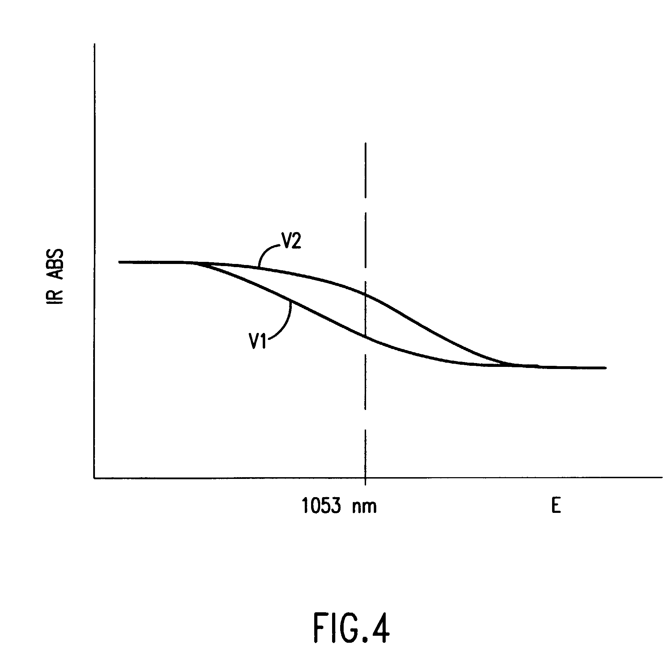

Figure 4 illustrates conceptually the change in infrared absorption IR Abs as a function of energy E. Changing the potential of gate electrode 200 between levels V1 and V2 subtly shifts the silicon band-gap energy level, and thus modulates the absorption of photons. This is the Franz-Keldysh effect. See, for example, N. SELIGER *et al., A Study of Backside Laser-Probe Signals in MOSFETs,* 5TH EUROPEAN CONFERENCE ON ELECTRON AND OPTICAL BEAM TESTING OF ELECTRONIC DEVICES, PRELIMINARY PROCEEDINGS, 27-30 August 1995, Wuppertal, Germany.

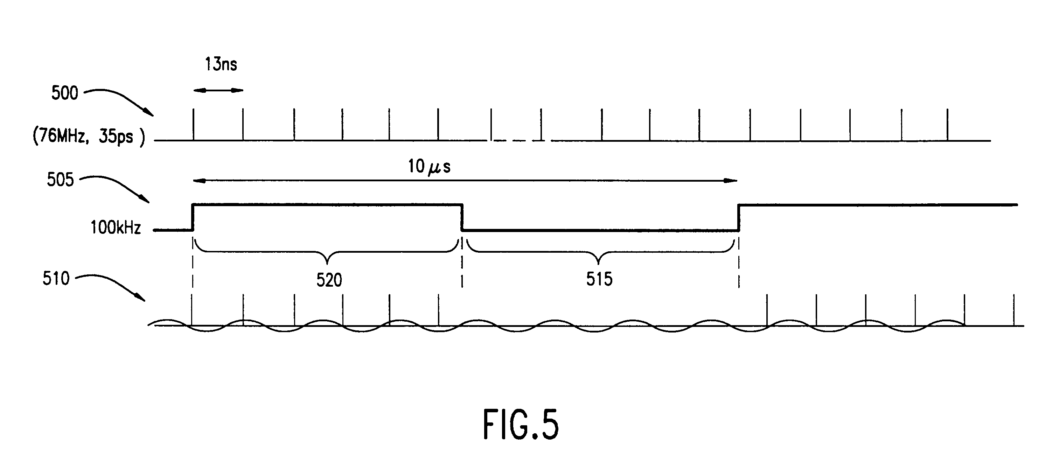

Figure 5 illustrates noise limitations of signal acquisition with the arrangement of Figure 1. A fixed sampling scheme is used. Line 500 shows the train of 35 ps sampling-pulses at a pulse rate of 76 MHz produced by laser source 105. The pulse repetition period of about 13 ns is possible because the signal being sampled on conductor 128 has a duty cycle of approximately the same length. Because the waveform is noisy, the sampling laser pulses are chopped at a lower frequency. Line 505 shows the 100 kHz laser-chop reference produced by shutter 110, having a period of 10 ps. Line 510 shows the resultant chopped laser pulses with noise (not to scale). Phase-sensitive rectifier 145 subtracts the noise of the detector signal while the laser is chopped off (e.g., the detector signal during interval 515) from the laser signal acquired when the laser pulses are passed (e.g. the detector signal during interval 520). Because the noise is random, the noise cancellation is imperfect. The scheme of Figure 5 may be acceptable for acquisition of repetitive signals of short duty cycle, such as the square wave (76 + Df MHz) applied to conductor 128 in the arrangement of Figure 1. However, this simple noise-cancellation scheme will result in unreasonably long signal-averaging times to recover typical waveforms found in ICs.

Other methods are also known for electro-optic sampling of electronics circuits. See, for example, U.S. Patent No. 4,681,449 of Bloom *et al.,* U.S. Patent No. 4,758,092 of Heinrich *et al.,* and H.K. HEINRICH *et al., Picosecond, backside optical detection of internal signals in flip-chip mounted silicon VLSI Circuits,* PREPRINTS, 3RD EUROPEAN CONFERENCE ON ELECTRON AND OPTICAL BEAM TESTING OF INTEGRATED CIRCUITS, Como, Italy, September 9- 11, 1991, pp. 261 et seq.

Methods are also known for double-gated integration of electron-beam test probe signals. See U.S. Patent No. 5,210,487 to Takahashi et al. However, use of such methods in laser-pulse sampling of ICs has not been proposed.

According to the present invention, repetitive stimulus signal is applied to an integrated circuit. A train of laser pulses is generated, and a laser pulse is picked from the train at a selected time during each repetition of the stimulus signal. The picked laser pulses are applied to a semiconductor active region of the integrated circuit which is influenced by voltage on a conductor. Photons reflected from the semiconductor active region are detected to produce a detector signal. The detector signal is sampled in synchrony with application of the laser pulses to the semiconductor active region so as to obtain samples during first gating intervals which depend upon reflected photons and noise and so as to obtain samples during second gating intervals which depend upon noise. Samples obtained during the first gating intervals are integrated with the inverse of samples obtained during the second gating intervals to produce an integrator signal representing a noise-compensated signal. The integrator signal can be compensated for pulse-to-pulse laser power variations.

The present invention will now be described with reference to the accompanying drawings, in which:
Figure 1 shows schematically a prior-art laser voltage probe arrangement;
Figures 2-4 illustrate the operating principles of the arrangement of Figure 1;
Figure 5 illustrates noise limitations of signal acquisition with the arrangement of Figure 1;
Figure 6 illustrates how the prior-art scheme of Figure 5 might be applied to acquisition of longer duty-cycle waveforms;
Figure 7 schematically illustrates the major elements of a laser-voltage probe system in accordance with the invention;
Figure 8 illustrates a dual-gated integrating scheme in accordance with the invention;
Figure 9 shows how gate-circuit switches of the Figure 8 arrangement are controlled in accordance with the invention;
Figure 10 shows a dual-gated integrating scheme with laser noise cancellation in accordance with the invention; and
Figure 11 shows an alternate dual-gated integrating scheme with laser noise cancellation in accordance with the invention.

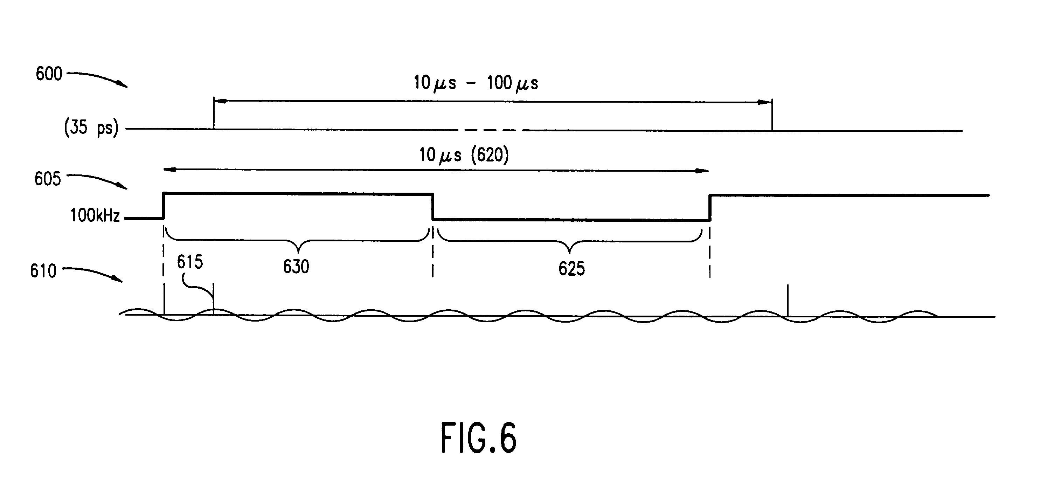

Referring now to the drawings, Figure 6 illustrates how the prior-art scheme of Figure 5 might be applied to acquisition of longer duty-cycle waveforms such as encountered in diagnosing a typical IC. In this case, the signal to be acquired has a duty cycle on the order of 10 ms to 100 ms, typically about 10 ms. A given point in the waveform is sampled once during this period, as represented by the pulses in line 600. If the sampling laser pulses are chopped at a rate of 100 kHz, as shown in line 605, only one sample is taken during each 10 ms sampling period. Line 610 shows the single sampling pulse 615 occurring during one sampling period 620, along with a representation of the noise. If phase-sensitive rectifier 145 subtracts the noise of the detector signal while the laser is chopped off(e.g. the detector signal during interval 625) from the laser signal acquired when the laser pulses are passed (e.g. the detector signal during interval 630), there is much noise but little signal. With the very low signal power from such long duty-cycle acquisition, averaging a sufficient number of such pulses to obtain an acceptable signal-to-noise ratio will require an unacceptably long time. In the example of Figure 6, taking one sample each 10 ps period would require averaging for thousands of seconds to obtain a usable signal-to noise ratio. Acquiring a complete waveform from a typical IC conductor with such a scheme would be impractical.

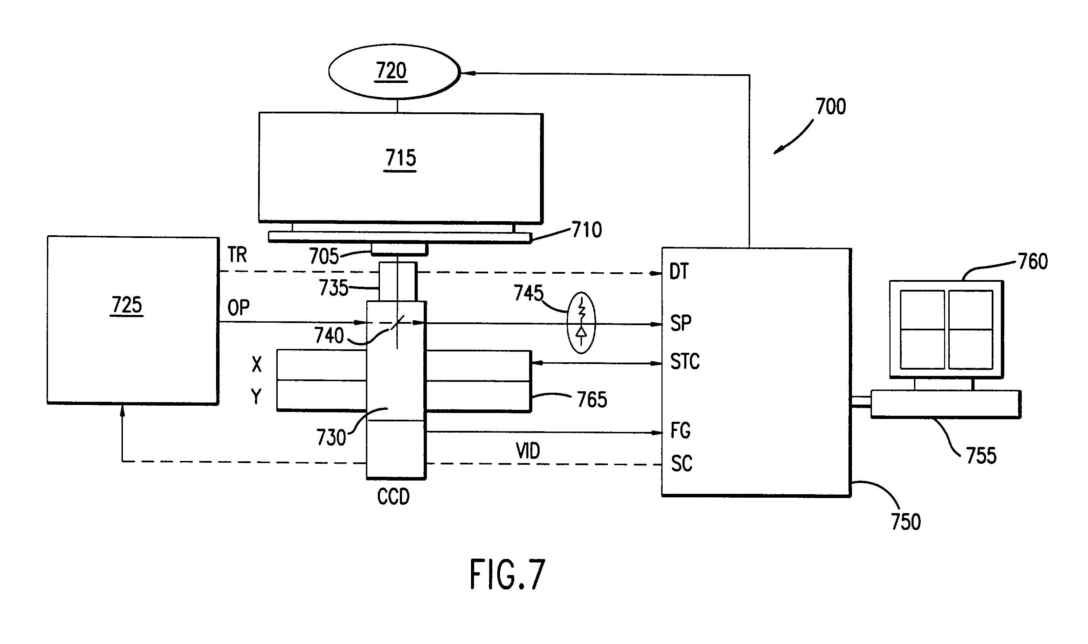

Figure 7 schematically illustrates the major elements of a laser-voltage probe system 700 in accordance with the invention. The system advantageously employs laser-pulse sampling as shown in Figure 2 while incorporating an improved signal acquisition technique. An IC device under test (DUT) 705 is carried on a load board 710 which is connected to the test head 715 of a conventional test system 720. A signal pattern is applied to DUT 705 by test system 720. A laser subsystem 725 generates optical pulses OP which are applied via an optical microscope 730 and infrared (IR) objective 735 to a region of interest within DUT 705. The pulses may be applied through the backside of DUT 705 to a gate, conductor, or other structure of DUT 705, particularly if DUT 705 is of "flip-chip" design having restricted access to such structure from the front side.

Photons reflected from DUT 705 are passed to a photodiode 745 which supplies a corresponding detector signal to a signal processing SP portion of an electronics subsystem 750. Electronics subsystem 750 includes a digital timebase DT portion which receives a timing reference signal TR from laser subsystem 725 for synchronization of test system 720 with the laser pulse train. A system control SC portion of electronics subsystem 750 controls operation of laser subsystem 725; for example, laser subsystem 725 may include a pulse picker such as a Pokel cell for selectively passing optical pulses to optical microscope 730. A charge-coupled device (CCD) has a view of DUT 705 through optical microscope 730 and passes a video signal VID to a frame grabber FG within electronics subsystem 750 for capturing an image of DUT 705. The image can be displayed using a computer workstation 755 having a display screen 760. A waveform produced from the photodiode detector signal can also be displayed on display screen 760. Optical microscope 730 is mounted on an X-Y stage 765 which is controlled by a stage controller StC portion of electronics subsystem 750. Optical microscope 730 can be positioned relative to DUT 705 by viewing the video image on display screen 760. Display screen 760 is shown divided into windows. Respective windows can be used to display a video image of DUT 705, a waveform on a conductor of DUT 705 acquired by sampling with the laser optical pulses, CAD layout data of DUT 705, a circuit schematic of DUT 705, etc.

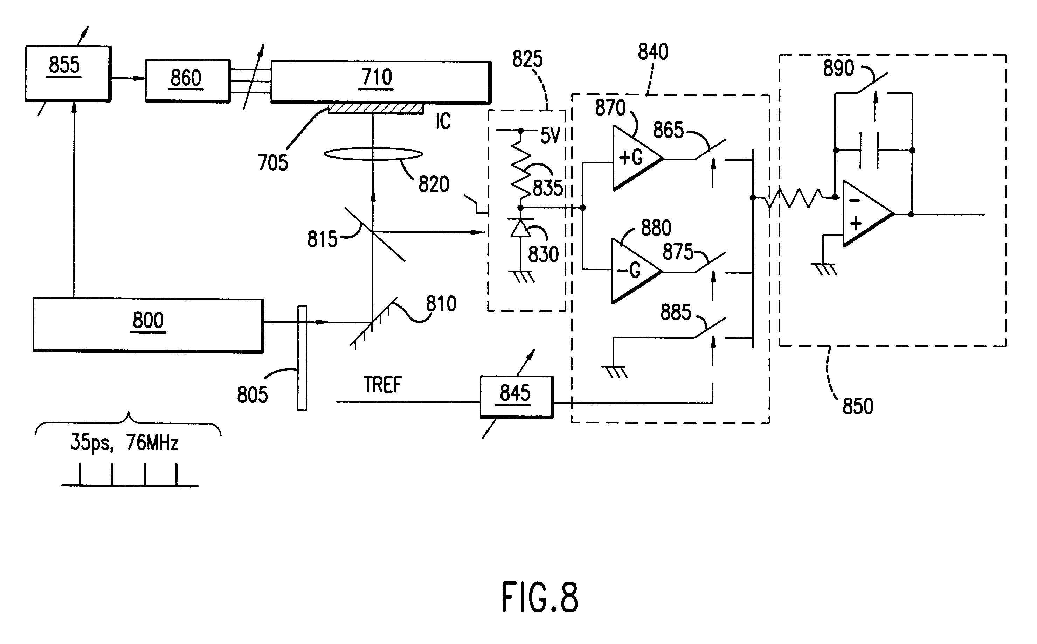

Figure 8 illustrates a dual-gated integrating scheme in accordance with the invention. The scheme can be implemented in a system having the architecture of Figure 7. For simplicity of illustration, control lines and other features of a complete system are not shown in Figure 8.

A free-running mode-locked generator 800 produces pulses of, for example, 1053 nm at a repetition frequency of 76 MHz and period of 35 ps. An electro-optical pulse picker 805 responsive to a system controller allows selected laser pulses to be passed for sampling of IC 705. The selected pulses are applied to IC 705 via a reflector 810, beam splitter 815 and optics 820. Photons reflected from IC 705 pass via optics 820 and beam splitter 815 to a detector circuit 825 having, for example, a photodiode 830 in series with a resistor 835. Detector circuit 825 supplies a detector signal to a gating circuit 840 for purposes which are described below. Gating circuit 840 is controlled by a timing reference signal T Ref having a tunable delay as shown schematically at 845. The tunable delay is used to align gating pulses time-wise with the detector pulses. The signal from gating circuit 840 is averaged in an integrator 850. The waveform output from integrator 850 can be further averaged and displayed if desired and the integrator reset by operation of switch 890 when needed. A timing reference signal T Ref from laser generator 800 is provided to a timebase circuit 855 which controls the timing of a stimulus source 860 of test system 720. Stimulus source 860 drives IC 705 via load board 710.

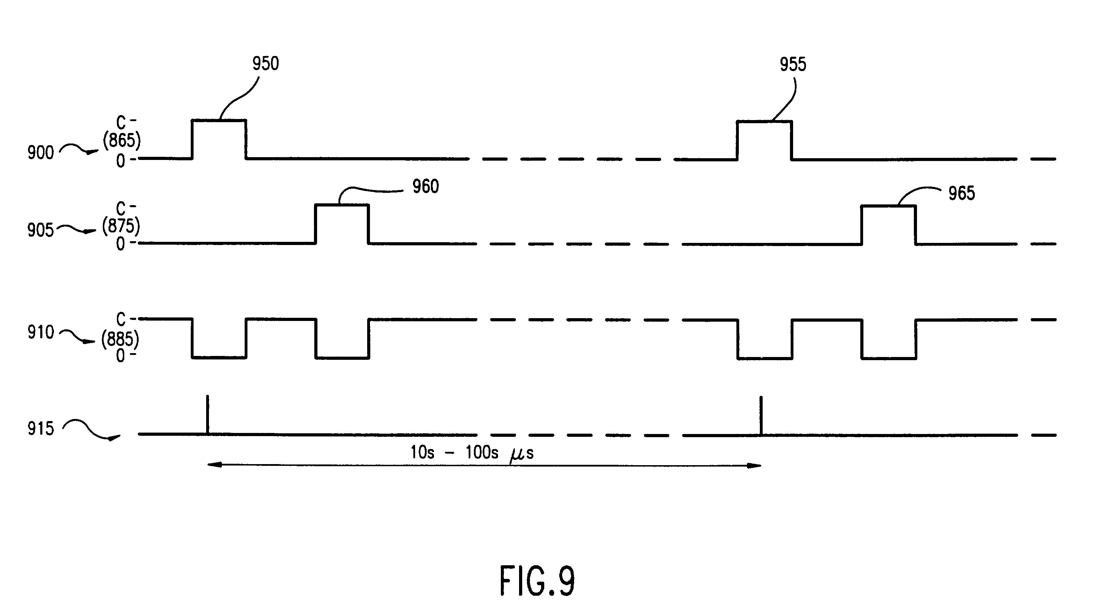

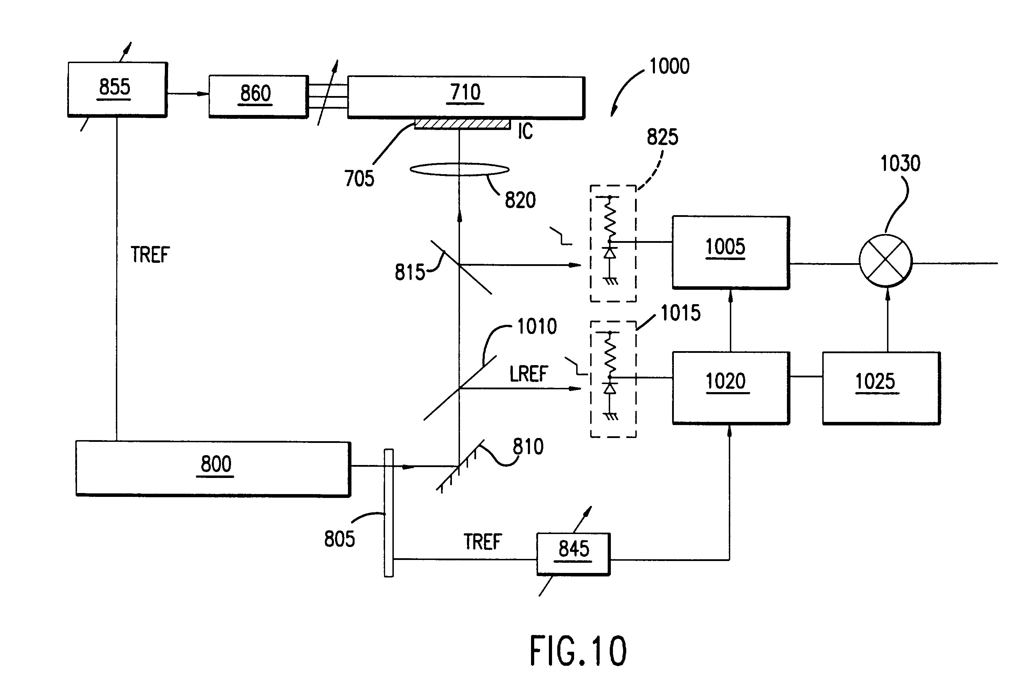

Gating circuit 840 has a first controllable switch 865 which, when closed, passes the detector signal from amplifier 870 to integrator 850 with a suitable non-inverted gain +G. Gating circuit 840 has a second controllable switch 875 which, when closed, passes the detector signal from amplifier 880 to integrator 850 with a suitable inverted gain -G. Gating circuit 840 has a third controllable switch 885 which, when closed, passes a null signal to integrator 850. In operation, DUT 705 is exercised by a repetitive test signal pattern from stimulus source 860 which is synchronized with laser pulses of generator 800. A picker control signal selects laser pulses which are to be passed by pulse picker 805 for sampling of a conductor of DUT 705. Photons reflected from DUT 705 modulate the detector signal from detector circuit 825 which is passed to gate circuit 840.
Control of gate-circuit switches 865, 875 and 885 is shown in Figure 9. Line 900 shows that when a laser sampling pulse is expected, switch 865 is closed C for a short interval 950, 955, etc., to pass the detector signal to integrator 850 with a gain of +1. Switch 865 is otherwise maintained open O. During the interval when switch 865 is closed, the detector signal passed to integrator 850 contains signal information as well as noise. Line 905 shows that, to compensate this noise, switch 875 is closed C for a comparable interval 960, 965, etc., so that a portion of the detector signal containing only noise is passed to integrator 850 with a gain of -1. Line 910 shows that, between the sampling intervals of lines 900 and 905, switch 885 is closed to null the input to integrator 850. During sampling intervals 950, 955, 960, 965, etc., switch 885 is open O to allow the detector signals to pass to integrator 850. Proper timing of the sampling intervals will result in substantial noise cancellation. For example, if intervals 960 and 965 closely follow intervals 950 and 955, respectively, the sampled noise which is subtracted from the sampled signal-plus-noise will closely match the noise component of the signal-plus-noise. The dual-gated scheme of Figure 9 compares, for example, with the dual-gating scheme described for an electron-beam probe system in U.S. Patent No. 5,210,487 (see patent Figure 9 and related description). Of course, other sampling relationships can also be used, such as the gating schemes described for an electron-beam probe system with reference to Figures 10 and 12 of U.S. Patent No. 5,210,487. In the scheme of Figure 12 of U. S . Patent No. 5,210,487, the duration of the noise sampling interval differs from the duration of the signal-plus-noise sampling interval, and a gain is applied which compensates for the difference.

For simplicity of illustration, integrator 850 is schematically shown in Figure 8 as an analog circuit. Such a circuit can be used to sample a waveform by appropriate control of reset switch and detector-signal sampling intervals. That is, when enough detector signal samples taken at a given point in the repetitive waveform on DUT 705 have been integrated, the resulting measurement is passed to an analog-to-digital converter and then stored for display and/or further digital signal averaging. The measurement process is repeated for each point in the repetitive waveform.

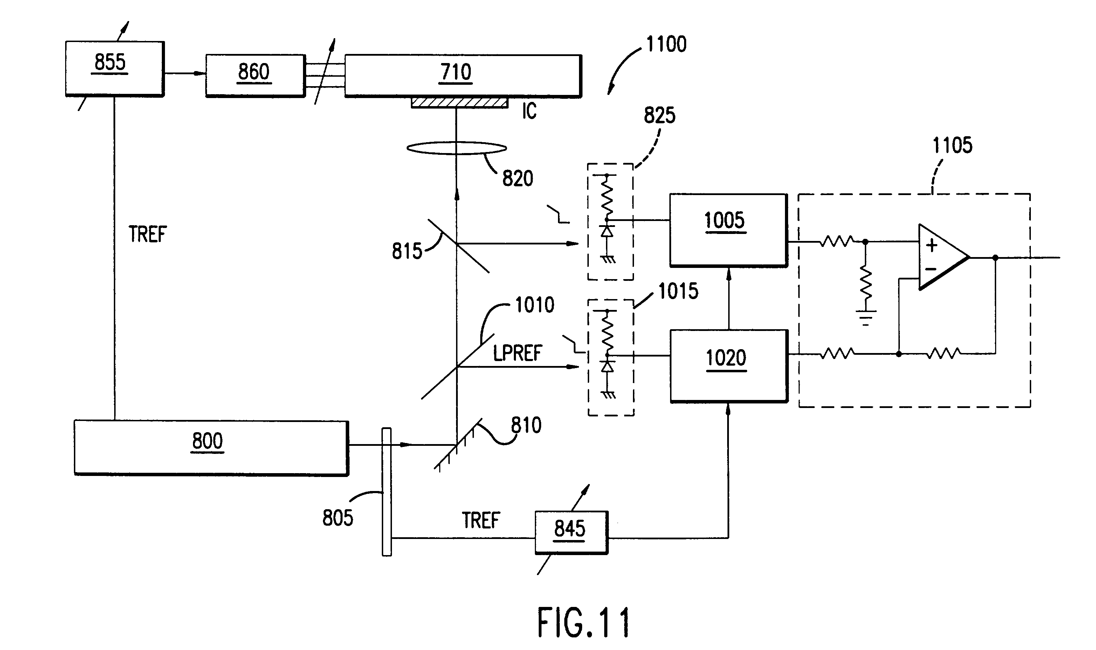

Integrator 850 can be replaced with a digital integrator if desired. In this case, the detector signal is digitized before integration and the integration can be performed in a digital circuit or programmable digital signal processor. See, for example, the digital signal processing scheme described with reference to Figure 11 of U. S. Patent No. 5,210,487. Digital integration allows well-known multisampling techniques to be used, in which samples at multiple points in the DUT's waveform are taken during each repetition of the waveform. Samples taken at any given point in the waveform over many such repetitions are averaged to produce a measurement for that point. Multi-sampling has the advantage of reducing waveform acquisition time by integrating samples at each point in the waveform during each repetition of the waveform.
With a mode-locked laser-pulse generator, such as a YLF or YAG source, power can vary from pulse to pulse. The effect which is measured with the gated laser pulses is photon absorption in a semiconductor active region influenced by potential on a conductor. The measured effect is weak, and the measurement can be adversely affected by pulse-to-pulse power variation. The scheme of Figure 8 can be modified to compensate for such variation.

Figure 10 shows a dual-gated integrating scheme 1000 with laser noise cancellation in accordance with the invention. Like items are indicated with like reference numerals. The detector signal from detector circuit 825 is supplied to a dual-gating integrator 1005, such as gating circuit 840 and integrator 850, as in the arrangement of Figure 8. A beam splitter 1010 passes a portion of each laser pulse as a laser power reference to a detector circuit 1015. Detector circuit 1015 supplies a laser power reference signal to a dual gating integrator 1020 comparable to dual-gating integrator 1005. Dual-gating integrators 1005 and 1020 are controlled by the timing reference signal from tunable delay 845 as described above. Dual-gating integrator 1005 produces a noise compensated signal as described above. Dual-gating integrator 1020 produces a noise compensated laser-power reference signal L Ref which is supplied to a scaling element 1025. Scaling element 1025 prepares a scaling multiplier which compensates for variation in laser-pulse power, either per pulse or averaged over multiple pulses depending on photodiode and laser noise characteristics. For example, scaling element 1025 can prepare for each laser pulse a multiplier which is equal to the average laser-pulse power over some time interval divided by the actual laser-pulse power for the current laser pulse. The noise-compensated signal from dual-gating integrator 1005 is multiplied by the scaling multiplier in a multiplier 1030. Figure 11 shows an alternate dual-gated integrating scheme 1100 with laser noise cancellation in accordance with the invention. In this case, a differential amplifier circuit 1105 takes the difference between the laser-reference signal produced by dual-gating integrator 1020 and the measurement signal produced by dual-gating integrator 1005. The difference signal from differential amplifier circuit 1105 is thus compensated for laser-pulse-power variation on a pulse-by-pulse basis.

Those of skill in the art will recognize that normalization of laser-power variations as in Figures 10-11 can be implemented in hardware or in software, e.g. in a digital signal processor.

The laser power reference signal can be produced in various ways. For example, a smaller portion of the laser pulse can be split off for producing the laser power reference than is passed to the IC for measurement purposes. The difference in amplitude can be compensated by changing the gain. The laser power reference can alternatively be taken directly from laser generator 800 (e.g. from a mirror within laser generator 800) rather than from a separate beam splitter 810. The foregoing description of preferred embodiments of the invention is intended as illustrative only, and not as a limitation of the invention as defined by the claims which follow.

## Claims

1. A method of measuring voltage of a conductor of an integrated circuit, comprising:
a) applying a repetitive stimulus signal to an integrated circuit;
b) generating a train of laser pulses;
c) picking a laser pulse at a selected time during each repetition of the stimulus signal;
d) applying the picked laser pulses to a semiconductor active region of the integrated circuit influenced by voltage on said conductor;
e) detecting photons reflected from the semiconductor active region to produce a detector signal;
f) sampling the detector signal in synchrony with application of the laser pulses to the semiconductor active region so as to obtain samples during first gating intervals which depend upon reflected photons and noise and so as to obtain samples during second gating intervals which depend upon noise; and
g) integrating samples obtained during the first gating intervals with the inverse of samples obtained during the second gating intervals to produce an integrator signal representing a noise-compensated signal.

2. A method as claimed in claim 1, wherein the integrated circuit has a substrate, wherein step d) comprises applying the picked laser pulses to the semiconductor active region through the substrate.

3. A method as claimed in claim 1 or 2, further comprising the step of integrating a null signal in between the first gating intervals and second gating intervals.

4. A method as claimed in claim 1, 2 or 3, further comprising compensating the integrator signal for variations in laser pulse power.

5. A method as claimed in claim 4, wherein compensating the integrator signal comprises:
sampling laser pulses to produce a laser-pulse-power reference signal, preparing a scaling multiplier from the laser-pulse-power reference signal, and multiplying the integrator signal with the scaling multiplier.

6. A method as claimed in claim 4, wherein compensating the integrator signal comprises: sampling laser pulses to produce a laser-pulse-power reference signal, and preparing a difference signal representing the difference between the integrator signal and the reference signal.

7. Apparatus for measuring signal on a conductor of an integrated circuit, comprising:
a) a test system for applying a repetitive stimulus signal to an integrated circuit;
b) a laser generator for generating a train of laser pulses;
c) a pulse picker for picking a laser pulse at a selected time during each repetition of the stimulus signal;
d) a laser-optical column for applying the picked laser pulses to a semiconductor active region of the integrated circuit which is influenced by voltage on said conductor;
e) a detector circuit for detecting photons reflected from the semiconductor active region to produce a detector signal;
f) a gating circuit for sampling the detector signal in synchrony with application of the laser pulses to the conductor so as to obtain samples during first gating intervals which depend upon reflected photons and noise and so as to obtain samples during second gating intervals which depend upon noise; and
g) an integrator for integrating samples obtained during the first gating intervals with the inverse of samples obtained during the second gating intervals to produce an integrator signal representing a noise-compensated signal.

8. Apparatus as claimed in claim 7, further comprising a compensator for compensating laser pulse power variations.

9. Apparatus as claimed in claim 8, wherein the compensator comprises a detector for sampling laser pulses to produce a laser-pulse-power reference signal, a scaler responsive to the laser-pulse-power reference signal for preparing a scaling multiplier, and a multiplier for multiplying the integrator signal with the scaling multiplier.

10. Apparatus as claimed in claim 8, wherein the compensator comprises a detector for sampling laser pulses to produce a laser-pulse-power reference signal, and a differences for preparing a difference signal representing the difference between the integrator signal and the reference signal.
